# EUROPEAN PATENT APPLICATION

(11) **EP 4 600 704 A1**
(43) Date of publication of application: **13.08.2025**
(21) Application number: 24157173.6
(22) Date of filing: 12.02.2024
(51) Int. Cl.: G01V 3/10, G01V 3/28, G01D 11/24, H03K 17/95

(54) **INDUCTIVE SENSOR**

(71) Applicant: Pepperl+Fuchs SE (Berlin), 12277 Berlin (DE)
(72) Inventor: KARIMI, Abdullah, 68623 Lampertheim (DE); BRAUNSMANN, Christoph, 67273 Dackenheim (DE)
(74) Representative: Tergau & Walkenhorst Intellectual Property GmbH

(57) **Abstract**

An inductive sensor (1) for detecting metallic objects, comprising:
- a sensor housing (4) having a first housing surface (41), which represents the active surface of the sensor (1);
- coil system (2) having a front face (21), wherein the front face (21) is positioned rearwardly in front of the first housing surface (41) facing a rearward housing surface (44);
- a vertical positioning element (5), wherein the vertical positioning element (5) is configured and arranged to exert a force on the coil system (2) in the direction of, and preferably perpendicular to, the active surface (41) and the rearward housing surface (44), such that the front face (21) of the coil system (2) remains in direct contact with the rearward housing surface (44) of the sensor (1), wherein the vertical positioning element (5) is formed by and/or attached to the sensor housing (4).

## Description

### FIELD OF THE INVENTION

The present invention relates to an inductive sensor for detecting metallic objects, a sensor system comprising a plurality of such sensors and a method of assembling such inductive sensor.

### BACKGROUND OF THE INVENTION

Inductive sensors are widely used for various applications, such as in automotive, industrial, and consumer electronics sectors. These sensors operate based on the principle of detecting a change of the impedance or the impulse response of a coil system or a change of the inductive coupling between multiple coil systems when a metallic object is in proximity to the sensor. The precise positioning of the coil system in the sensor is crucial for accurate detection of metallic objects. In the existing technology, it is important to precisely position the coil system or systems in both vertical and lateral directions with respect to the rear surface of the sensor housing to ensure that the sensor reacts correctly to the object being detected. During operation, the coil system should not shift or displace laterally, and the front face of the coil system should maintain in contact with the rear surface of the sensor housing. Standard casting resins and adhesives are commonly used for securing the coil system in place. However, these resins often lack sufficient temperature resistance. Additionally, the thermal expansion coefficient of the resin and the other sensor components usually differs significantly, which may result in thermally induced mechanical strains and displacements especially of the coil system, leading to problems in the operation and accuracy of the sensor. One approach to address these issues involves the use of silicone-based casting materials, which are suited for higher operating temperatures. However, this method still requires long waiting times for the curing of the casting materials and necessitates special machines for casting, such as vibrating plates. Moreover, adhesives and casting materials may be harmful to the environment and can complicate the overall assembly process.

These and other problems are solved by the subject matter of the attached independent claims.

### SUMMARY OF THE INVENTION

The present invention aims to provide an improved inductive sensor that overcomes the aforementioned drawbacks. The present invention pertains to an inductive sensor designed for detecting metallic objects, particularly suitable for applications in automation technology and motion detection of parts, including lateral continuous motion. The invention offers several advantages over the prior art, including simpler manufacturability, no waiting time for adhesive drying, and no need for silicone or resin-based casting materials. This eliminates curing times and the need for special casting machines. Additionally, the invention eliminates the need for adhesives, making it more environmentally friendly. Additionally, the sensor, sensor system and the method according to the present invention enable for cost savings, particularly as the needed additional parts compared to the prior art, for example, a spring, nut, and centering pin, are much cheaper compared to resin-hardener-based encapsulation or silicone encapsulation with process effort as currently used in the art. Thereby, the present inventors have found that it is important to position the coil system or coil systems of inductive sensors precisely in both vertical and lateral directions with the front face on the back of a housing surface to ensure that the sensor reacts correctly to the object to be detected. During operation, the coil system or coil systems should be arranged stable and particularly not undergo lateral movements or lateral displacements to large extent and the end face should not lose contact with the rear wall of the housing, even if the material expands due to temperature. Therefore, the inventive sensor is uniquely structured to withstand high operating temperatures and accurately detect the vertical or lateral approach of target objects.

The core of the invention is that in an inventive inductive sensor the coil system is positioned facing a rearward housing surface of the sensor housing thereby utilizing a vertical positioning element, such as a spring element, that exerts a force on the coil system in the direction of the active surface of the sensor and, more particularly the rearward housing surface, such that the front face of the coil system remains in direct contact with the rearward housing surface of the sensor. Additionally, a lateral positioning element, for example a centering pin, is provided to ensure a positioning of the coil system in any direction lateral to the active surface. A skilled person will thereby immediately acknowledge and understand that such lateral positioning element, depending on the respective embodiment, additionally may also provide positioning in another direction, particularly a vertical direction. In that way the front face of the coil system remains in an attended and predetermined position in relation to the rearward housing surface such that the sensor reacts accurately to an object to be detected.

It shall be noted that the core of the invention also is the resilient mounting of the entire coil system. Thereby, a compensation of mechanical impact and/or temperature-induced material expansion is achieved, which otherwise causes the coil system to lose contact with the back of the front surface. Without the wish to be bound by theory, the present inventors believe that the mechanical stability also at high temperatures is important. The material is chosen accordingly, to expand as little as possible, however, also irreversible material expansion may occur, which may be compensated to large extent by the vertical positioning element, particularly the spring.

The invention thereby also addresses temperature-induced material expansion by utilizing the vertical positioning element, such as a spring element, to compensate for the expansion. The material used in the sensor housing preferably has a very small expansion coefficient, minimizing unwanted expansion of the active surface. Particularly, the sensor housing is preferably made from a material, such as PEEK with a high glass fiber content, selected to minimize material expansion. Unlike standard casting resins typically used in sensor manufacturing, which lack temperature resistance, the inventive sensor does not require the use of such resins. This eliminates the need for waiting times for adhesive drying and resin curing, simplifying the manufacturing process. Furthermore, the invention provides precise lateral positioning through the lateral positioning element, such as a small diameter centering pin, and thereby prevents lateral displacement of the coil system during operation.

In addition, the inventors have surprisingly found that the centering pin, i.e. the lateral positioning element, in combination with the spring ring, i.e. the vertical positioning element, provides an advantageous system, wherein the lateral positioning element provides a support for a pulling force of the entire coil system, particularly via the vertical positioning element. Such force application resulting from the combination of the lateral and vertical positioning element, i.e. in a more narrow embodiment from the interplay of the centering pin and the spring ring. This is found to be advantageous by the inventors in avoiding bulging effects.

Thus, the invention provides an inductive sensor with improved performance, manufacturability, and resilience to high operating temperatures.

### DETAILED DESCRIPTION OF THE INVENTION

The above objects of the invention are achieved by an inductive sensor, a sensor system comprising a plurality of sensors and a method of assembling an inductive sensor according to the annexed claims.

Preferred embodiments may be taken from the dependent claims, and, beyond that, from the following description, in particular comprising various embodiments as covered and described in the annexed claims.

The skilled person will understand that any embodiment described in the following description is covered and comprised by the subject matter covered by the annexed claims.

The embodiments, features and combination of features as described herein in connection with the invention, as well as the combination of features as given in the annexed claims, but also any combination of features as mentioned and described in connection with the embodiments shall be considered as being disclosed herein, at least, however, shall be considered to be derivable by the skilled person.

In particular, each feature and each combination of features in the embodiments as described herein may for example be claimed in a different combination, in particular different claim category, at least because the skilled person will recognize that each and every combination of the features mentioned herein is suitable for contributing to solving the underlying problem.

Further, each feature and each combination of features in the claims and used in the description below may be used and claimed independently from the respective claimed subject matter, independently from claim dependencies and back-references, and independently from the claim category in which the feature is claimed. For example, in an arbitrary combination selected from one or more claims, one or more embodiments as set forth herein below and/or from the annexed figures may be envisaged.

An inductive sensor for detecting metallic objects according to the present invention comprises at least:
- a sensor housing having a first housing surface, which represents the active surface of the sensor;
- coil system having a front face, wherein the front face is positioned rearwardly in front of the first housing surface facing a rearward housing surface;
- a vertical positioning element wherein the vertical positioning element is configured and arranged to exert a force on the coil system in the direction of, and preferably perpendicular to, the active surface and the rearward housing surface, such that the front face of the coil system remains in direct contact with the rearward housing surface of the sensor, wherein the vertical positioning element is formed by and/or attached to the sensor housing.

Thereby, the sensor housing preferably refers to the physical structure or casing that houses the internal components of the sensor. It has a first housing surface, which represents the active surface of the sensor. This is the surface through which the sensor interacts with its environment to detect metallic objects.

The coil system of the inventive sensor preferably refers to the primary sensing component of the sensor. It has a front face, which is positioned rearwardly in front of the first housing surface, facing a rearward housing surface. The coil system is responsible for generating an electromagnetic field that is used to detect the presence of metallic objects by the sensor.

The vertical positioning element refers to a component configured and arranged to exert a force on the coil system in the direction of the active surface and the rearward housing surface. This ensures that the front face of the coil system remains in direct contact with the rearward housing surface of the sensor despite any potential changes in temperature or other conditions that might otherwise cause it to move.

Thereby, the vertical positioning element, keeps the coil system in contact with the active surface of the sensor. The vertical positioning element, which may be particularly designed as a resilient element or a spring element, can compensate for reversible material expansions.

The inventive sensor may further include at least one ferrite core, particularly as a part of the coils system, that increases inductance and strengthens sensitivity towards the front.

Within the present application, terms such as "axial", "radial", "lateral", "vertical" or "laterally", "vertically", "rear", "frontal", "upper", "lower", "bottom", "opposite", "inner", "outer" or the like, as used herein, which describe the position of a first object relative to another object, preferably refer to the relative position of a respective part or object with regard to its position fully mounted for its intended use.

In an advantageous embodiment of the inventive sensor, the inductive sensor according to the present invention further comprises a lateral positioning element. Such lateral positioning element is configured and arranged to ensure a positioning of the coil system in any direction lateral, particularly radial, to the active surface, such that the front face of the coil system remains in an attended and predetermined position in relation to the rearward housing surface, and wherein preferably the lateral positioning element is formed by and/or attached to the sensor housing. Preferably the lateral positioning element is formed by and/or attached to the rearward housing surface.

Advantageously with such configuration of the inventive sensor it is ensured that the front face of the coil system advantageously remains in an attended and predetermined position, particularly such that the sensor reacts correctly to an object to be detected. In other words, the vertical and/or the lateral positioning reduces advantageously tolerances of the coil system and the corresponding measurement uncertainties of the sensor. The precise positioning of the coil system increases the efficiency of the sensor, and the response of the sensor is ensured, even with small lateral deviations.

It shall be understood that "Lateral" is preferably understood as a direction in a parallel plain of the active surface of the sensor. As various sensor configurations and geometries may be realized in the scope of the invention, lateral may be also understood preferably as a direction in the main plain of a coil of the sensor. Particularly lateral may also refer to "radial", preferably if a radial coil system is used.

In an advantageous embodiment of the inventive sensor, the vertical positioning element and/or the lateral positioning element is formed by and/or attached to the sensor housing. Thereby, it shall be understood that the vertical positioning element may be formed by the sensor housing. Alternatively, or additionally, the vertical positioning element may also be attached to the sensor housing. Thereby, the integration of the vertical positioning element with the sensor housing can simplify the design, reduce parts, and enhance structural integrity. It may lead to a more compact and robust sensor assembly. In relation to the lateral positioning element, also this may be formed by the sensor housing. Alternatively, or additionally, the lateral positioning element also may be attached to the sensor housing. Similar to vertical positioning element, integrating or attaching the lateral positioning element to the sensor housing can improve the overall stability and precision of the sensor. It may contribute to a more reliable and durable sensor construction.

In a further advantageous embodiment of the inventive inductive sensor the sensor housing is provided in a multipart form, comprising at least a main housing part and a coil hood part, and wherein the vertical positioning element and/or the lateral positioning element is formed by and/or attached to the coil hood part of the sensor housing.

This advantageously allows for greater flexibility and ease during the assembly process of the inductive sensor. By having the sensor housing in a multipart form, comprising at least a main housing part and a coil hood part, individual components can be manufactured, handled, and assembled separately. This can simplify the manufacturing process, allow for more efficient quality control of individual parts, and potentially reduce the cost of production.

Moreover, having the vertical positioning element and/or the lateral positioning element formed by and/or attached to the coil hood part of the sensor housing ensures a secure and precise positioning of the coil system. This arrangement can enhance the reliability and accuracy of the sensor by maintaining the correct alignment of the coil system, which is crucial for the sensor's operation. It also simplifies the assembly process, as the positioning elements are integrated into the coil hood part of the sensor housing, reducing the number of separate components that need to be assembled.

In a further advantageous embodiment of the inventive inductive sensor the vertical positioning element comprises a spring element to exert a force on the coil system in the direction of the rearward housing surface.

This advantageously ensures that the coil system maintains constant contact with the rearward housing surface, which is crucial for the correct operation of the sensor. The spring element in the vertical positioning component provides a consistent force that keeps the coil system in place, even when environmental conditions such as temperature changes cause material expansion. By using a spring element, the sensor can automatically adjust to these changes, maintaining the correct positioning of the coil system and ensuring accurate detection of metallic objects. This design enhances the reliability and performance of the sensor, making it more adaptable to varying operating conditions.

Preferably the vertical positioning element and/or the lateral positioning element is positioned or attached rearwardly to the active surface, to exert a force on the coil system in the direction of the active surface and the rearward housing surface.

This advantageously ensures that the coil system is always in the correct position relative to the active surface of the sensor, which is crucial for accurate detection of metallic objects. By positioning or attaching the vertical positioning element and/or the lateral positioning element rearwardly to the active surface, the elements exert a force on the coil system in the direction of the active surface and the rearward housing surface. This arrangement keeps the front face of the coil system in direct contact with the rearward housing surface, even under conditions that could cause material expansion, such as temperature changes. This design enhances the reliability and accuracy of the sensor, ensuring consistent performance under varying operating conditions.

According to the present invention a spring element may have various forms, particularly selected from the group comprising spring ring, compression springs, disc springs, leaf springs, spring washer, diaphragm springs, claws, snap hooks, generally resilient solid joints, or rubber springs.

Thereby, a skilled person will understand how to design or choose the respective vertical positioning element in accordance with the intended purpose of the present invention. This advantageously provides flexibility in the design and functionality of the inductive sensor. Different types of spring elements can be selected based on specific application requirements, environmental conditions, or desired sensor characteristics. For example, a rubber spring might be used in environments where resistance to corrosion is important, while a disc spring might be selected for applications requiring a high load capacity in a small space. This versatility in the choice of spring elements enhances the adaptability of the sensor to a wide range of applications and operating conditions, improving its overall performance and utility. This also advantageously allows the sensor to be customized to a wide range of applications and operating conditions, enhancing its versatility and performance. The ability to modify the geometry and material composition of the coil hood and spring element provides flexibility in the design and manufacturing of the sensor, potentially leading to improved sensor characteristics and cost efficiencies.

In a further advantageous embodiment of the inventive inductive sensor the lateral positioning element comprises a centering pin.

This advantageously ensures precise positioning of the coil system within the sensor housing, which is crucial for the accurate detection of metallic objects. The lateral positioning element comprises a centering pin, which may particularly work in conjunction with the coil hood or respective housing part, to position the coil system laterally, or even both laterally and vertically.

The centering pin helps maintain the coil system in the correct lateral position, i.e., perpendicular to the axis of the sensor, while the vertical positioning element may support to maintain the correct vertical position, i.e., along the axis of the sensor. This dual positioning mechanism ensures that the coil system is always perfectly aligned within the sensor housing, regardless of any external factors or conditions that might otherwise cause misalignment. Furthermore, the use of a centering pin simplifies the assembly process, as it provides a straightforward means of aligning and securing the coil system within the sensor housing. This can lead to efficiencies in the manufacturing process, potentially reducing production time and costs. Overall, the use of a centering pin as part of the lateral positioning element significantly enhances the reliability, accuracy, and manufacturability of the inductive sensor. Particularly, in such configuration the coil system may advantageously designed to be adjusted to the centering pin. For example, the coil system may comprise a through-hole, particularly a central recess, through which the centering pin may be received. This is particularly preferred, in embodiments, where the centering pin at its distant portion has a thread portion to receive a nut provided to fasten the coil system.

In an embodiment of the sensor according to the present invention, the lateral positioning element may particularly be configured to secure the vertical positioning element. For example, in a particular embodiment the centering pin as the lateral positioning element is also configured to hold and/or secure the spring element, and thus simultaneously position vertically and prevent any lateral displacements.

In an advantageous embodiment, the centering pin is preferably a rigid element, but alternatively, it can also be elastic and/or designed to be flexible. In particular, the centering pin can be provided with a spring force, such that the centering pin also serves as a spring element itself. Particularly, in one embodiment the centering pin may be configured and provided to be a spring element to exert a force on the coil system in the direction of the rearward housing surface. For such purpose, the centering pin may comprise further spring elements, such as spring latches, or the like.

In a further advantageous embodiment of the inventive inductive sensor the vertical positioning element, particularly the spring element, is attached to and/or secured to the lateral positioning element, particularly the centering pin. This advantageously simplifies the assembly process and enhances the stability and reliability of the sensor. By attaching and/or securing the vertical positioning element, particularly the spring element, to the lateral positioning element, particularly the centering pin, these two elements can work together to maintain the precise positioning of the coil system. This combined positioning mechanism ensures that the coil system remains in the correct alignment both laterally and vertically, which is crucial for the accurate detection of metallic objects. It also ensures that the coil system maintains constant contact with the rearward housing surface, even under conditions that could cause material expansion, such as temperature changes. Furthermore, this design reduces the number of separate components that need to be assembled, which can simplify the manufacturing process and potentially reduce production costs. It also enhances the structural integrity of the sensor, as the spring element and centering pin can provide mutual support to each other, enhancing the overall durability and lifespan of the sensor. Overall, attaching and/or securing the spring element to the centering pin provides significant advantages in terms of the sensor's performance, reliability, and manufacturability.

In a further advantageous embodiment of the inventive inductive sensor the sensor housing and/or the lateral positioning element, particularly the centering pin, comprises a threaded portion, and wherein the sensor housing and/or the vertical positioning element comprises a nut, wherein the nut is for fixing the coil system to the rearward housing surface.

This advantageously allows for a secure and adjustable attachment of the coil system within the sensor housing. The threaded portion on the sensor housing or the lateral positioning element, particularly the centering pin, in conjunction with the nut screwed onto the thread of the vertical positioning element, provides a means of precisely adjusting and fixing the position of the coil system. This ensures that the coil system maintains constant contact with the rearward housing surface, which is crucial for accurate detection of metallic objects. Furthermore, this design simplifies the assembly process and enhances the overall reliability and durability of the sensor.

In a particularly preferred embodiment, the vertical positioning element is provided in the form of a spring ring, and the lateral positioning element in the form of a centering pin. Thereby, the centering pin may be provided attached to the rearward housing surface, particularly of a coil hood part, such that the coil may be slipped on the centering pin, followed by a spring ring and the nut. Accordingly, the nut fastens the coil system with the front face positioned rearwardly in front of the first housing surface facing the rearward housing surface and the spring ring as the vertical positioning element exerts a force on the coil system in the direction of the active surface and the rearward housing surface, such that the front face of the coil system remains in direct contact with the rearward housing surface of the sensor. The centering pin serves as the lateral positioning element and ensures correct positioning of the coil system in any direction lateral to the active surface, such that the front face of the coil system remains in an attended and predetermined position in relation to the rearward housing surface such that the sensor reacts correctly to an object to be detected. Thereby, the initial spring force of the spring ring can be precisely adjusted through the torque applied to the fixing nut. In other words, the coil system is vertically guided over the centering pin and fixed onto the rear housing surface by means of the spring assembly comprising the spring ring and the nut. This prevents the lateral displacement of the coil system during operation. The spring assembly ensures that, despite material expansion, which may also be irreversible, the end face of the coil system remains in contact with the housing rear wall.

The nut according to the present invention may be provided in various forms and may particularly be selected from hexagon nut in flat form, tall form, quick-release nut, square nut, with clamping, flange nut, crown nut, acorn nut, wing nut, ring nut, slotted nut, knurled nut, castle nut. The method of fixation can be adapted or altered in terms of form, material, and functionality. In principle, an alternative form of fixation can be used, for example, could involve screws or bolts with threads, or a groove or notch, for example provided at the distal end of the centering pin. Additionally or alternatively, the centering pin may be secured using spring washers, retaining rings, lock ring, or circlips, preferably replacing the traditional nut. Another possible embodiment comprises a centering pin equipped with a snap hook, where fixation could be achieved using components like washers instead of a nut. Furthermore, a centering pin featuring a bayonet closure is also conceivable.

In a further embodiment of the inductive sensor the precise lateral positioning is achieved by the centering pin with the inner diameter of the coil system, the inner diameter being smaller than the outer coil diameter or housing diameter, and having smaller tolerances.

In a further advantageous embodiment of the inventive inductive sensor the vertical positioning element, particularly the spring element, is positioned at and/or attached to the coil system, particularly a rear portion of the coil system. This advantageously ensures a direct application of force to the coil system, enhancing the sensor's performance and reliability. By positioning or attaching the vertical positioning element, particularly the spring element, to the coil system, the spring element can exert a direct force on the coil system, maintaining its correct positioning. This design ensures that the coil system remains in constant contact with the rearward housing surface, which is crucial for accurate detection of metallic objects. Furthermore, this arrangement simplifies the assembly process and reduces the number of separate components, potentially leading to cost and time efficiencies in the manufacturing process.

In a further advantageous embodiment of the inventive inductive sensor the coil system comprises a through-hole, particularly a central recess, and wherein the through-hole, particularly the central recess, comprises a thread, preferably an internal thread. This advantageously provides a means for securely attaching and adjusting the coil system within the sensor housing. The through hole, particularly a central recess, in the coil system that comprises a thread, preferably an internal thread, allows for precise adjustments to be made to the positioning of the coil system. This design ensures that the coil system remains in the correct alignment within the sensor housing, which is crucial for accurate detection of metallic objects. Furthermore, this arrangement simplifies the assembly process and enhances the overall reliability and durability of the sensor. This may further allow that the coils system is directly screwed on to a respective element, particularly a centering pin, with a respective fitting counter thread, eg. external thread. For example, the centering pin being attached to or forming a part of a coil hood may provide such thread and the coils system may directly be screwed on the thread of the centering pin. A person skilled in the art will understand that in such embodiments, the thread as such may present the vertical positioning element. Additionally, however, also in such embodiments an additional spring element may advantageously used to compensate, for example, reversible material expansions.

In a further advantageous embodiment of the inventive inductive sensor the sensor housing, particularly the main housing part and/or the coil hood part is manufactured from a material having a material expansion coefficient alpha of less than 125ppm/K, preferably of less than 100ppm/K, more preferably of less than 75 ppm/K, still more preferably of less than 50 ppm/K, most preferably of less than 25 ppm/K.

In a further advantageous embodiment of the inventive inductive sensor the sensor housing, particularly the main housing part and/or the coil hood part is manufactured from a material of low material expansion coefficient alpha, particularly Polyether-etherketone (PEEK) with a high proportion of glass fibers.

Thereby, the person skilled in the art knows various methods to determine the material coefficient alpha. Representative values for such material coefficient alpha may preferably be about 18 ppm/K for PEEK having 30% glass fiber content, which is particularly preferred and significantly lower compared with other material. However also PEEK without glass fiber material may be used, which has a material coefficient alpha of about 60 ppm/K. In comparison thereto, PTFE may show a material expansion coefficient alpha of about 130 ppm/K.This advantageously enhances the performance and reliability of the inductive sensor by minimizing the impact of temperature-induced material expansion. The use of a material such as Polyetherether-ketone (PEEK) with a high proportion of glass fibers for the sensor housing, particularly the main housing part and/or the coil hood part, ensures that the sensor maintains its structural integrity and dimensional stability even under varying temperature conditions. This material choice reduces the risk of misalignment of the coil system, which is crucial for accurate detection of metallic objects. Furthermore, the use of such materials can enhance the overall durability and lifespan of the sensor, making it more cost-effective in the long run. It is to be understood that PEEK is particularly useful at very high temperatures of sensor usage. Additionally, PEEK is advantageous as a material that does not affect the electromagnetic field.

In a further advantageous embodiment of the inventive inductive sensor the sensor housing, particularly the main housing part and/or the coil hood part is manufactured from a material selected from plastics, comprising ether ketones and fluoroplastics, particularly PFA, PTFE and PEEK, preferably PEEK.

In a further advantageous embodiment of the inventive inductive sensor the sensor housing, particularly the main housing part and/or the coil hood part is manufactured from a metallic material with a low conductivity and permeability like stainless steels or metallic glass. Such a material usually influences the electromagnetic field of the sensor only slightly, particularly at low operating frequencies. Coil hoods made of ceramics may also be applied within the scope of the present invention. Ceramic coil hoods are hard and extremely temperature-resistant, but also may tend to be brittle and generally more difficult to process.

A "high portion of glass fibers" as referred to herein, preferably refers to at least 15%, preferably at least 20% more preferably at least 25%, most preferably at least 30%.

A person skilled in the art will immediately acknowledge that a PEEK without glass fibers would have about 3 times higher expansion. Ideally, the expansion should be zero, while other factors such as workability, chemical resistance, etc. may have to be considered in addition.

The material of the sensor housing and particularly a coil hood as a component of the active surface, may deliberately be chosen to minimize material expansions. In this regard, PEEK with a high proportion of glass fibres is preferred.

In comparison to a coil hood made of Teflon, elastoplastic material expansions caused by rearward forces on the coil system may cause the active surface to significantly bulge, up to 1-2 mm in extreme cases, e.g. at high temperatures. In contrast, the bulging of the active surface made of PEEK was found by the inventors to be <_ 0.1 mm. A bulging effect as referred to herein, may be preferably detected and determined as a flatness deviation, which can be determined tactually and optically.

In a further advantageous embodiment of the inventive inductive sensor the sensor housing is provided in a multipart form, and at least one first housing part of the sensor housing, comprises a fastening mechanism, preferably a bayonet lock mechanism, configured to attach said first housing part of the sensor housing to at least one second housing part of the sensor housing.

In a further advantageous embodiment of the inventive inductive sensor the sensor housing is provided in a multipart form, and at least one first housing part of the sensor housing, comprises a fastening mechanism, preferably a thread, snap hook or a bayonet lock mechanism, or the like, configured to attach said first housing part of the sensor housing to at least one second housing part of the sensor housing, wherein said second housing part of the sensor housing preferably is the coil hood part. Advantageously, the coil hood part may comprise a thread provided on the outer inner diameter of the coil hood part.

In such configuration, it is of particular advantage that such thread provided on the outer inner diameter of the coil hood part may be formed as an integral part of the coil hood part. Such thread may advantageously engage with a respective counter-thread, for example, provided at the outer diameter of the coil system or a part thereof. This thread and/or the coil hood part of the sensor can be made from a suitable metal or plastic material, particularly a glass fiber reinforced plastic. In an embodiment, the coil hood part of the sensor housing may have various shapes and forms, particularly selected from the group comprising a coil hood part of cuboid or cylindrical shape, or a combination of both shapes.

A fastening mechanism, preferably a thread or a bayonet lock mechanism, provided and configured to attach said first housing part of the sensor housing to at least one second housing part of the sensor housing, advantageously simplifies the assembly and disassembly process of the inductive sensor, making it more user-friendly and maintenance-friendly. By providing the sensor housing in a multipart form with a fastening mechanism, preferably a thread or bayonet lock mechanism, the different parts of the sensor housing can be easily attached or detached from each other. This can be particularly beneficial during maintenance or repair operations, as it allows for easy access to the internal components of the sensor. Furthermore, the use of a fastening mechanism, preferably a bayonet lock mechanism, ensures a secure and reliable connection between the different parts of the sensor housing, enhancing the overall structural integrity and durability of the sensor. Thereby, a housing part containing the coil system, which can be anchored in a second housing part by a bayonet lock may be assembled through a simple rotational movement. Additionally, a spring element can also be attached behind the coil system, i.e. distal to the active surface of the sensor, to press the coil system onto the active surface of the sensor.

Additionally, a centering pin, with or without a thread, can be incorporated into the design.

This embodiment advantageously provides flexibility in the design and assembly of the inductive sensor. The inclusion of a thread on the outer inner diameter of the coil hood part allows for precise adjustments and secure attachment of the coil system within the sensor housing. The use of suitable materials for the thread, such as metal or specific types of plastic, can enhance the sensor's performance by minimizing potential issues related to material expansion or bulging. However, it will be understood by a person skilled in the art that the material of the thread as such may have less effects on bulging than the material of the coil hood and/or housing as such. Here, and particularly for the active surface, a material having a beneficial material expansion property is to be chosen. Particularly, a bulging is known in the prior art to occur mainly on the front and side surface of the coil hood part of the sensors of the prior art. Accordingly, the inventors consider to choose a material for the coil hood part that is providing more stability, for example, in one embodiment of the present invention, the housing, and particularly the coil hood part is manufactured from a material having a material expansion coefficient alpha of less than 125ppm/K, preferably of less than 100ppm/K, more preferably of less than 75 ppm/K, still more preferably of less than 50 ppm/K, most preferably of less than 25 ppm/K, most preferably the material is PEEK.

The ability to shape the active surface, represented by the coil hood, as a cuboid, a cylinder, or a combination of both, along with the option of incorporating a centering pin, provides versatility in the sensor design, enabling it to be tailored to specific application requirements. In a further advantageous embodiment of the inventive inductive sensor the vertical positioning element, particularly in the form of a spring element, is formed as a part of or attached to the rearward housing surface.

This advantageously ensures a direct application of force to the coil system, enhancing the sensor's performance and reliability. By forming the vertical positioning element, particularly the spring element, as a part of or attaching it to the rearward housing surface, the spring element can exert a direct force on the coil system, maintaining its correct positioning. This design ensures that the coil system remains in constant contact with the rearward housing surface, which is crucial for accurate detection of metallic objects. Furthermore, this arrangement simplifies the assembly process and reduces the number of separate components, potentially leading to cost and time efficiencies in the manufacturing process.

In such an embodiment, the spring element may be provided, particularly in the form of one or a several snap hooks, clips or clamps, with sufficient spring action over the entire temperature range.

Particularly, in a further advantageous embodiment of the inventive inductive sensor, the vertical positioning element and/or the lateral positioning element, particularly the spring element, is made of metal. This may advantageously ensure that sufficient spring action is provided over the entire temperature range.

In a further advantageous embodiment of the inventive inductive sensor, the vertical and/or lateral positioning elements is formed as part, preferably integral part, of the sensor housing, preferably as components of the main housing part and/or the coil hood part. This integration is preferably achieved through injection moulding, wherein the spring element or any attachment and alignment feature for the spring element is seamlessly incorporated into the injection moulding process. Notably, the sensor housing, particularly the coil hood may be manufactured by injection moulding technology, and the vertical positioning element, particularly a spring element or any attachment and alignment feature for such spring element, and/or the lateral positioning element, such as the threaded centering pin, can be formed as an integral part during the injection moulding process.

The above-described problems are also advantageously solved by a sensor system comprising plurality of sensors according to the present invention. Such a sensor system comprising plurality of sensors, particularly is provided for linear positioning. The sensor of such sensor system is an inductive sensor according to the present invention. Thereby, the sensor system may comprise the sensors according to the present invention as individual units or parts, or may comprise a plurality of sensors, provided on a joint printed circuit board (PCB). Accordingly, a coil system of such sensor system may comprise a plurality of sensors according to the present invention, and/or a plurality of coils, each or the plurality having a front face, wherein the front face is positioned rearwardly in front of the first housing surface facing a rearward housing surface. Also in such system at least one vertical positioning element is provided configured and arranged to exert a force on at least one of the plurality of coils of such coil system, or in relation to a coil of a sensor comprised in the system. Independent from whether a plurality of coils is provided or a plurality of sensors is provided in such system, the force provided is exerted in the direction of, and preferably perpendicular to, the active surface and the rearward housing surface, such that the front face of the coils and/or the coil system remains in direct contact with the rearward housing surface of the sensor(s), wherein each vertical positioning element of the system is formed by and/or attached to the sensor housing.

This advantageously resolves the challenges by presenting a sensor system consisting of multiple sensors, aligning seamlessly with the principles of the present invention. This system, specifically designed for linear positioning, capitalizes on the innovative features introduced earlier. The sensors within this system adhere to the inventive inductive sensor design, ensuring enhanced precision and reliability in linear positioning applications. Through this advantageous embodiment, the sensor system stands as a comprehensive solution, effectively addressing the issues posed by integrating multiple sensors for linear positioning tasks.

In a particularly preferred embodiment of the inductive sensor of the present invention the sensor comprises a sensor housing having a first housing surface, which represents the active surface of the sensor, a coil system having a front face, wherein the front face is positioned rearwardly in front of the first housing surface facing a rearward housing surface, and a vertical positioning element wherein the vertical positioning element is configured and arranged to exert a force on the coil system in the direction of, and preferably perpendicular to, the active surface and the rearward housing surface, such that the front face of the coil system remains in direct contact with the rearward housing surface of the sensor, wherein the vertical positioning element is formed by and/or attached to the sensor housing, and wherein the sensor housing is provided in a multipart form, comprising at least a main housing part and a coil hood part, and wherein the vertical positioning element and/or the lateral positioning element is formed by and/or attached to the coil hood part of the sensor housing, and wherein the vertical positioning element and/or the lateral positioning element is formed as part of the sensor housing, preferably part of a main housing part and/or part of a coil hood part.

The above-described problems are also advantageously solved by a method of assembling an inductive sensor according to the present invention. Such method of assembling an inductive sensor comprises at least the following steps:
- a step of providing a sensor housing having a first housing surface, which represents the active surface of the sensor;
- a step of providing a coil system having a front face;
- a step of positioning the coil system with the front face rearwardly in front of the first housing surface facing a rearward housing surface such that the front face of the coil system is in direct contact with the rearward housing surface of the sensor;
- a step of providing a vertical positioning element such that the vertical positioning element exerts a force on the coil system in the direction of the active surface and the rearward housing surface;
- and a step of providing a lateral positioning element to ensure a positioning of the coil system in any direction lateral to the active surface, such that the front face of the coil system remains in an attended and predetermined position in relation to the rearward housing surface.

That the front face of the coil system remains in an attended and predetermined position in relation to the rearward housing surface particularly ensures that the sensor reacts correctly to an object to be detected.

It shall be noted, that the steps given above do not necessarily have to be carried out in the given order. The provided steps may be carried out in any other suitable order.

However, the order as given above may apply for particular variants of the method. For example, a step of providing a vertical positioning element may be carried out in embodiment, where the vertical positioning element is a spring element after a step of positioning the coil system over a centering pin. However, in other embodiments, the steps of providing a vertical positioning element and providing a lateral positioning element may be carried out during the injection moulding process of manufacturing a housing part, and thus before a step of positioning the coil system.

It will be immediately acknowledged by a person skilled in the art that a feature, embodiment, effect or advantage described herein in connection with the inventive inductive sensor and sensor system, may also be a feature, embodiment, effect or advantage of the inventive method, respectively, and vice versa.

All described embodiments of the invention have the advantage, that the inventive sensor is of improved applicability, particularly in the field of automation technology and motion detection of parts, including lateral continuous motion. The sensor is capable of operating at high temperatures up to 250°C and ensures accurate detection. One of the key advantages of this sensor is its easier manufacturability. There is no need for adhesive drying or casting compound curing, eliminating waiting times. This is a significant improvement over the use of standard casting resins, which are not temperature-resistant. It also allows for precise positioning of the coil system in both vertical and lateral directions, ensuring that the sensor reacts correctly to the object to be detected. Even during operation and potential material expansion due to temperature, the coil system can be arranged stably and particularly does not undergo lateral movements or position shifts to large extent, and maintains contact with the rear wall of the housing. The design of the sensor thereby advantageously ensures that the ferrite core is not pressed through the coil cap. The sensor does not require silicone casting or resin-based casting, making it more environmentally friendly as such chemicals are avoided. This also simplifies the assembly process, as the coil system can be manufactured as a module with the housing.

Overall, the inventive sensor design ensures that the coil front face remains constantly in contact with the sensor active surface. Temperature-induced material expansions are compensated by the vertical positioning element, particularly a spring element, if present. The preferred and suggested material used for the sensor has a very small expansion coefficient, minimizing unwanted expansion of the active surface.

The sensor's design also prevents the coil system from shifting laterally during operation and allows for precise lateral positioning via the lateral positioning element, particularly a small diameter centering pin. Combining a spring element, in the form of e.g. a spring ring and the centering pin having a thread for a fixing nut, the initial spring force can be precisely adjusted through the torque applied to the fixing nut, providing additional flexibility and control in the sensor's operation.

### BRIEF DESCRIPTION OF THE FIGURES

The present invention will be described in further detail with reference to the drawings from which further features, embodiments and advantages may be taken, and in which:
Fig. 1 shows a schematic overview of a sensor of the prior art;
Fig. 2A, 2B, 2C and 2D show different views and representations of a sensor according to a first embodiment of the present invention;
Fig. 3 shows a schematic representation of a second alternative embodiment of the present invention.

The features of the present invention disclosed in the specification, the claims, examples and/or the figures may both separately and in any combination thereof be material for realizing the invention in various forms thereof.

In the embodiments shown in the figures, elements similar or identic in function are designated with like reference signs. It is noted, that the figures may not be true to scale with respect to each other.

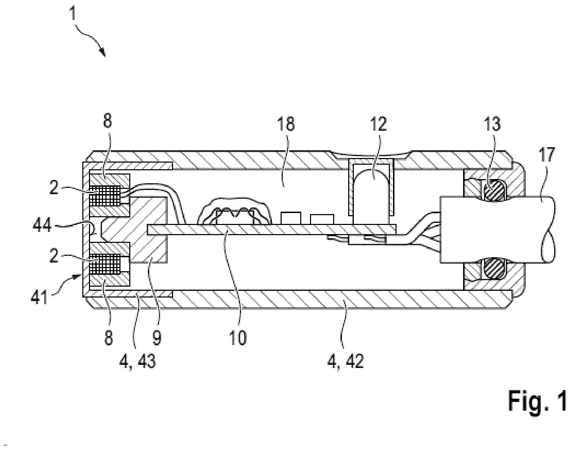

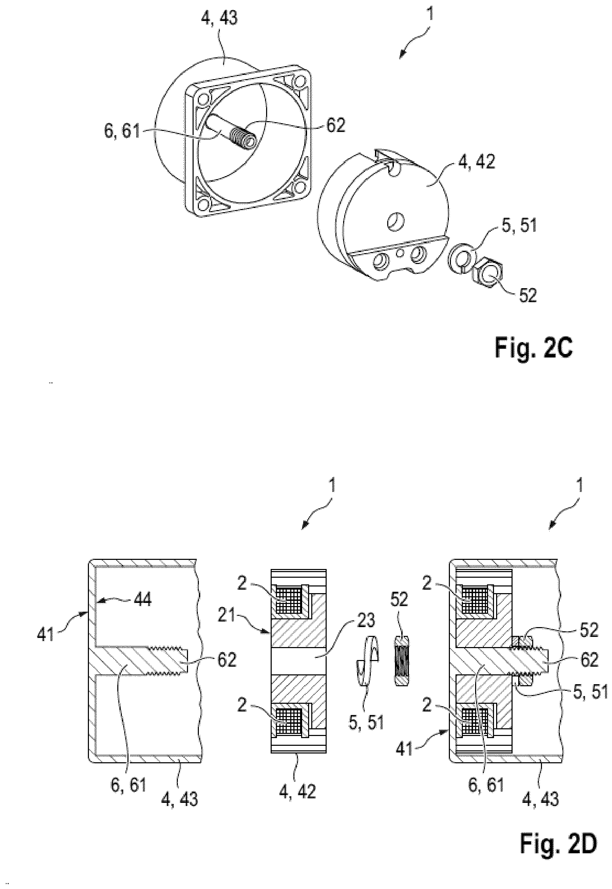

FIG 1 shows a schematic drawing of an inductive sensor (1) of the prior art for detecting metallic objects. The inductive sensor (1) comprises a sensor housing (4) having a first housing surface (41), which represents the active surface of the sensor (1). The sensor housing (4) is further divided into a main housing part (42) and a coil hood part (43). The sensor housing (4) is designed to protect the internal components of the sensor (1) from external factors. Inside the sensor housing (4), a coil system (2) is positioned. The coil system (2) has a front face (21) (not shown in FIG 1, however analogous to FIG 2D), which is positioned rearwardly in front of the first housing surface (41) facing a rearward housing surface (44). The positioning of the coil system (2) is crucial for the correct functioning of the sensor (1).

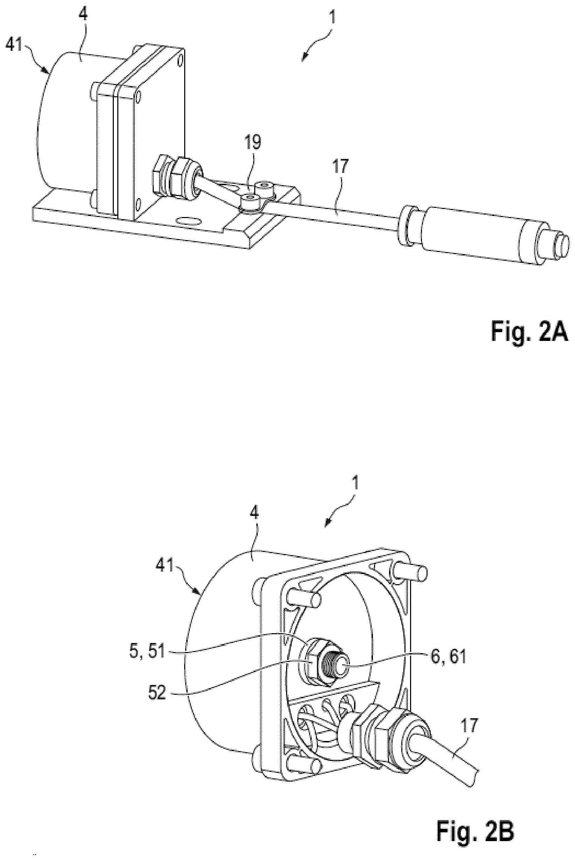

The coils system (2) as used herein preferably refers to the arrangement comprising the coil as such, and may particularly comprise further parts attached to the coil and/or in functional relation to the coil, particularly a bobbin, i.e. the winding body, visible in FIG 2D, and a ferrite core (8). In FIG 1, a bodyless coil wound with a self-bonding wire is shown, which uses a special winding technology to operate without a winding body.

As can be seen from FIG 1, the coil system (2) comprises at least one ferrite core (8) and is attached to a PCB holder (9). The ferrite cores (8) are designed to enhance the inductive properties of the coil system (2), while the PCB holder (9) provides structural support to the PCB relative to the coil system (2). A Printed Circuit Board (PCB) (10) is also included in the sensor (1). The electronic circuit on the PCB (10) is responsible for processing the signals received from the coil system (2) and converting them into useful data. The PCB (10) is housed within the sensor housing (4) for protection. The sensor (1) also includes an LED (12) for indicating the operational status of the sensor (1). The LED (12) provides a visual indication of the operational status of the sensor (1), allowing for easy troubleshooting. A seal (13) is provided to prevent the ingress of dust or moisture into the sensor housing (4). The sensor (1) is further connected to a cable (17) for transmitting the processed data to an external device. The sensor (1) is designed to detect the presence of metallic objects. When a metallic object comes into the vicinity of the sensor (1), particularly the active surface (41), it alters the inductive properties of the coil system (2). This change is detected by the coil system (2) and the information is sent to the PCB (10) for processing. The processed data is then transmitted through the cable (17) to an external device for further analysis.

As apparent from the drawing the entire internal components, particularly the coil system (2), ferrites (8), PCB (10) and other components are embedded in casting resin (18). Partially, the coil system may also be glued to the rearward housing surface (44) of the coil hood part (43) of the housing (4) with an adhesive (e.g. superglue) before potting. The coil is also usually glued into the core before assembly. In the following such components are not shown in detail and focus is drawn to the features relevant to explain inventive embodiments.

Fig. 2A, 2B, 2C and 2D show different views and representations of a sensor according to a first embodiment of the present invention. Referring to Figure 2A, an inductive sensor (1) for detecting metallic objects according to the present invention is shown in the form of a perspective schematic view in an assembled state. Thereby, the sensor (1) is mounted on and fixed to a mounting construction (19). The mounting construction (19) may have various geometries and can be tailored to the needs of the particular use of the sensor. Particularly, the mounting construction (19) may have guiding and holding structures to mount the sensor for its intended use, and/or to guide or mount, respectively, further components, such as a cable (17) for communication of the sensor (1) with respective electronics. Particularly when using inventive sensors (1) in high temperature environments of around 250°C, a placement of respective electronics outside of a high heat zone and connecting the sensor (1) with a longer cable (17) can be considered. FIG. 2B shows the sensor (1) dismounted from the mounting construction (19) in a perspective rear view, and Fig. 2C shows the sensor (1) in an exploded schematical view. Fig. 2D is a schematic cross-section of the sensor (1) in an exploded view on the left and an assembled view on the right. The inventive inductive sensor (1) for detecting metallic objects, comprises a sensor housing (4) having a first housing surface (41), which represents the active surface of the sensor (1). The sensor housing (4) is further divided into a main housing part (42) and a coil hood part (43). In other words, the inductive sensor (1) comprises a sensor housing (4) provided in a multipart form, comprising at least a main housing part (42) and a coil hood part (43). Within the housing (4) the coil system (2) is accommodated comprising the coils (2), and having a front face (21). Best seen from Fig. 2D said front face (21) is positioned rearwardly in front of the first housing surface (41) facing a rearward housing surface (44). As also can be best seen from Figs of 2D the sensor (1), comprises a vertical positioning element (5) in the form of a spring ring (5), that is exerting a force F on the coil system (2) in the direction of the active surface (41) and the rearward housing surface (44) when mounted, such that the front face (21) of the coil system (2) remains in direct contact with the rearward housing surface (44) of the sensor (1). Additionally, a lateral positioning element (6) in the form of the centering pin (6, 61) is provided to ensure a positioning of the coil system (2) in any direction lateral to the active surface (41), such that the front face (21) of the coil system (2) remains in an attended and predetermined position in relation to the rearward housing surface (44) such that the sensor (1) reacts correctly to an object to be detected. Both, the vertical positioning element (5) and/or the lateral positioning element (6) may be formed by and/or attached to the coil hood part (43) of the sensor housing (4). Here, the vertical positioning element (5) is attached to the coil hood part (43) of the sensor housing (4), as the lateral positioning element (6) is formed as an integral part of the housing (4) through injection moulding. In the shown embodiment of the invention the lateral and vertical positioning of the coil system (2) is enabled by the coil hood (4, 43) with the centering pin (6, 61) on which a thread (62) is provided. Precise lateral positioning is achieved through the centering pin (6) with the inner diameter of the coil system (2), where the inner diameter is smaller than the outer coil diameter or housing diameter, thus exhibiting smaller tolerances. The coil system (2) is vertically guided over the centering pin (6) and fixed onto the rear housing surface (44) by means of a spring assembly (5), a spring ring (51), and a nut (52). This prevents the lateral displacement of the coil system (2) during operation. The spring assembly (5) with the nut (52) ensures that, despite material expansion, which may also be irreversible, the front face (21) of the coil system (2) remains in contact with the housing rear wall (44). In the shown embodiment the vertical positioning element (5) comprises said spring element (5), a spring ring (51), to exert a force F on the coil system (2) in the direction of the rearward housing surface (44). Also visible is that the vertical positioning element (5), particularly the spring element (51), is attached to and secured to the lateral positioning element (6), particularly the centering pin (61). As already indicated above it is best visible from Fig. 2C that the sensor housing (4) and particularly the lateral positioning element (6) in the form of the centering pin (61), comprises a threaded portion (62) onto which the nut (52) can be screwed to fasten the spring ring (5, 51), and thereby the nut (5, 52) is also fixing the coil system (2) to the rearward housing surface (44). Alternative possibilities for fixation are of course possible, as described herein in the general part of the description. Thereby, as can be seen best from the right figure of 2D, in an assembled state of the sensor (1), the vertical positioning element (5), particularly the spring element (51), is positioned at and attached to the coil system (2), particularly to a rear portion (22) of the coil system (2). In order to arrange the coil system (2) in the shown configuration with the central centering pin (6, 61) the coil system (2) comprises a through-hole (23) in the form of a central recess (23). Also alternatively, the coil hood part (43) may comprise a thread provided on the outer inner diameter of the coil hood part (43), and accordingly, the coil hood part may be screwed onto a respectively threaded counter part of the housing.

The present inventors have found that the sensor housing (4), particularly the main housing part (42) and/or the coil hood part (43), can be manufactured to be more resistant to high temperature induced bulging. Thereby a material capable of reducing material expansion, particularly PEEK, can be advantageously used, particularly with a relatively high portion of glass fibres.

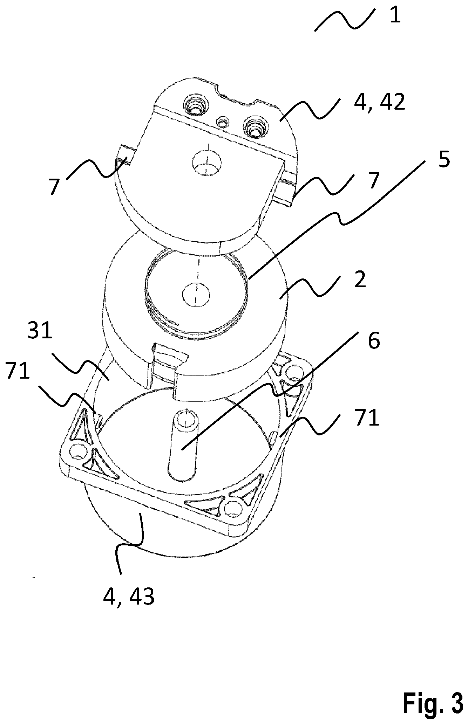

Fig. 3 shows a schematic representation of a second alternative embodiment of the present invention. Here, the housing (4) comprises the coil system (2). The sensor housing (4) may be provided in a multipart form, and at least one first housing part (43) of the sensor housing (4) may comprise a fastening mechanism (7) in the form of a bayonet lock mechanism (7) configured to attach said first housing part (42) of the sensor housing (4) to at least one second housing part (43) of the sensor housing (4). The second housing part (43) may comprise respective engagement elements (71), here in the form of a pair of pins (71), wherein each of the engagement elements (71) is provided to engage with the respective part of the bayonet mechanism (7). Also in such configuration, the vertical positioning element (5) may be provided as a spring element (5, 51), so that the coil system (2) is pushed towards the first housing surface and active sensor surface (41) of the sensor (1).

Alternatively to the bayonet lock mechanism other fastening mechanisms, like a thread, snap hook or the like, may be provided, configured to attach said first housing part (42) of the sensor housing (4) to the at least one second housing part (43) of the sensor housing (4), wherein said second housing part (43) of the sensor housing (4) preferably is the coil hood part (43). Advantageously, the coil hood part (43) may comprise a thread provided on the outer inner diameter (31) of the coil hood part (43). In such configuration, it is of particular advantage that such thread provided on the outer inner diameter (31) of the coil hood part (43) may be formed as an integral part of the coil hood part and engage with a respective counter-thread, for example, provided at the outer diameter of the coil system or a part thereof, or at the outer diameter of the first housing part (42) (here then in addition to or alternatively to the bayonet lock mechanism (7)).

Additionally, a centering pin (6) is provided in accordance with the embodiments shown in Fig. 2.

A major advantage of the present invention is that, the coils system (2) can be mounted in the sensor without the need of casting resins or other gluing material.

However, of course, in addition to the practice of the present invention, such resins or any other gluing material may still be used in some embodiments.

The embodiments in the figures may relate to preferred embodiments, while all elements and features described in connection with embodiments may be used, as far as appropriate, in combination with any other embodiment and feature as discussed herein, in particular related to any other embodiment discussed further above.

### LIST OF REFERENCE NUMERALS

- 1: inductive sensor
- 2: coil system
- 21: front face
- 22: rear portion
- 23: central recess
- 31: outer inner diameter of the coil hood part
- 4: sensor housing
- 41: first housing surface, active sensor surface
- 42: main housing part
- 43: coil hood part
- 431: coil hood surface
- 44: rearward housing surface
- 5.: vertical positioning element
- 51: spring element
- 52: nut
- 6.: lateral positioning element
- 61: centering pin
- 62: threaded portion
- 7: fastening mechanism, bayonet lock mechanism
- 71: engagement elements

- 8: ferrite core
- 9: PCB holder
- 10: PCB
- 11: Casing
- 12: LED
- 13: seal
- 17: cable, electronics
- 18: Casting resin
- 19: mounting construction

## Claims

1. An inductive sensor (1) for detecting metallic objects, comprising:
- a sensor housing (4) having a first housing surface (41), which represents the active surface of the sensor (1);
- a coil system (2) having a front face (21), wherein the front face (21) is positioned rearwardly in front of the first housing surface (41) facing a rearward housing surface (44);
an vertical positioning element (5) wherein the vertical positioning element (5) is configured and arranged to exert a force on the coil system (2) in the direction of, and preferably perpendicular to, the active surface (41) and the rearward housing surface (44), such that the front face (21) of the coil system (2) remains in direct contact with the rearward housing surface (44) of the sensor (1), wherein the vertical positioning element (5) is formed by and/or attached to the sensor housing (4).

2. The inductive sensor (1) according to claim 1, further comprising a lateral positioning element (6) configured and arranged to ensure a positioning of the coil system (2) in any direction lateral, particularly radial, to the active surface (41), such that the front face (21) of the coil system (2) remains in an attended and predetermined position in relation to the rearward housing surface (44), and wherein preferably the lateral positioning element (6) is formed by and/or attached to the sensor housing (4), preferably the rearward housing surface (44).

3. The inductive sensor (1) according to anyone of claims 1 or 2, wherein the sensor housing (4) is provided in a multipart form, comprising at least a main housing part (42) and a coil hood part (43), and wherein the vertical positioning element (5) and/or the lateral positioning element (6) is formed by and/or attached to the coil hood part (43) of the sensor housing (4).

4. The inductive sensor (1) according to anyone of the preceding claims, wherein the vertical positioning element (5) comprises a spring element (51) to exert a force on the coil system (2) in the direction of the rearward housing surface (44).

5. The inductive sensor (1) according to anyone of the preceding claims, wherein the lateral positioning element (6) comprises a centering pin (61).

6. The inductive sensor (1) according to anyone of the preceding claims, wherein the vertical positioning element (5), particularly the spring element (51), is attached to and/or secured to the lateral positioning element (6), particularly the centering pin (6).

7. The inductive sensor (1) according to anyone of the preceding claims, wherein the sensor housing (4) and/or the lateral positioning element (6), particularly the centering pin (61), comprises a threaded portion (62), and wherein the sensor housing (4) and/or the vertical positioning element (5) comprises a nut (52), wherein the nut (52) is for fixing the coil system (2) to the rearward housing surface (44).

8. The inductive sensor (1) according to anyone of the preceding claims, wherein the vertical positioning element (5), particularly the spring element (51), is positioned at and/or attached to the coil system (2), particularly a rear portion (22) of the coil system (2).

9. The inductive sensor (1) according to anyone of the preceding claims, wherein the coil system (2) comprises a through-hole, particularly a central recess, and wherein the through-hole, particularly the central recess, comprises a thread, preferably an internal thread.

10. The inductive sensor (1) according to anyone of the preceding claims, wherein the sensor housing (4), particularly the main housing part (42) and/or the coil hood part (43) is manufactured from a material having a material expansion coefficient alpha of less than 125ppm/K, preferably of less than 100ppm/K, more preferably of less than 75 ppm/K, still more preferably of less than 50 ppm/K, most preferably of less than 25 ppm/K.

11. The inductive sensor (1) according to anyone of the preceding claims, wherein the sensor housing (4), is provided in a multipart form, and at least one first housing part of the sensor housing (4), comprises a fastening mechanism (7), preferably a thread or a bayonet lock mechanism , configured to attach said first housing part of the sensor housing (4) to at least one second housing part of the sensor housing (4), wherein said second housing part of the sensor housing (4) preferably is the coil hood part (43).

12. The inductive sensor (1) according to anyone of the preceding claims, preferably of claim 11, wherein the coil hood part (43) comprises a thread provided on the outer inner diameter of the coil hood part (43).

13. The inductive sensor (1) according to anyone of the preceding claims, wherein the vertical positioning element (5) and/or the lateral positioning element (6) is formed as part of the sensor housing (4), preferably part of a main housing part (42) and/or part of a coil hood part (43), preferably of the rearward housing surface (44).

14. A sensor system comprising a plurality of sensors, particularly for linear positioning, wherein the sensors are inductive sensors (1) according to any one of the preceding claims.

15. Method of assembling an inductive sensor (1) comprising at least the steps of:
- providing a sensor housing (4) having a first housing surface (41), which represents the active surface of the sensor (1);
- providing a coil system (2) having a front face (21),
- positioning the coil system (2) with a front face (21) rearwardly in front of the first housing surface (41) facing a rearward housing surface (44) such that the front face (21) of the coil system (2) is in direct contact with the rearward housing surface (44) of the sensor (1);
- providing a vertical positioning element (5) such that the vertical positioning element (5) exerts a force on the coil system (2) in the direction of the active surface (41) and the rearward housing surface (44); and
- providing a lateral positioning element (6) to ensure a positioning of the coil system (2) in any direction lateral to the active surface (41), such that the front face (21) of the coil system (2) remains in an attended and predetermined position in relation to the rearward housing surface (44).
